# EUROPEAN PATENT SPECIFICATION

(11) **EP 3 102 017 B1**
(45) Date of publication and mention of the grant of the patent: **15.04.2020**
(21) Application number: 15743499.4
(22) Date of filing: 27.01.2015
(51) Int. Cl.: H05K 13/08, G05B 19/418

(54) **QUALITY MANAGEMENT APPARATUS AND QUALITY MANAGEMENT METHOD**
QUALITÄTSVERWALTUNGSEINRICHTUNG UND QUALITÄTSVERWALTUNGSVERFAHREN
DISPOSITIF DE GESTION DE QUALITÉ ET PROCÉDÉ DE GESTION DE QUALITÉ

(30) Priority: 30.01.2014 JP 2014015374
(43) Date of publication of application: 07.12.2016
(73) Proprietor: Omron Corporation, Kyoto-shi, Kyoto 600-8530 (JP)
(72) Inventor: MITSUDA Yuichi, Kyoto-shi Kyoto 600-8530 (JP); MORI Hiroyuki, Kyoto-shi Kyoto 600-8530 (JP); OGURA Yoshiharu, Kyoto-shi Kyoto 600-8530 (JP)
(74) Representative: Kilian Kilian & Partner
(86) International application number: PCT/JP2015/052204
(87) International publication number: WO 2015/115426

(56) References cited:
- EP-A1- 1 967 996
- EP-A2- 2 355 646
- WO-A1-2011/065428
- WO-A1-2012/137775
- JP-A- 2006 339 445
- JP-A- 2006 339 445
- JP-A- 2009 021 348
- US-A1- 2006 282 189

## Description

### TECHNICAL FIELD

The present invention relates to a technology of detecting a production facility abnormality that becomes a factor or a predictor of occurrence of a defect.

### BACKGROUND ART

In a production line in which automation and labor saving advance, sometimes an inspection apparatus is installed in an intermediate or final process of the line to automate defect detection or defective sorting. There is an attempt to use a causal factor, which is estimated from an inspection result of the inspection apparatus, in quality management or maintenance of a production facility.

As to a conventional example of a surface mounting line for a printed circuit board, Patent Document 1 discloses an idea of collecting and analyzing a result (a proportion defective and a variation in mounting position) of a post-mounting inspection in each nozzle of a mounter, each cassette, or each combination of the nozzle and the cassette, and of making use of the result in identification of the problematic nozzle or cassette. Patent Document 2 discloses an idea of collecting the proportion defective of a post-reflow final inspection in each nozzle of the mounter, and of presenting information about the nozzle degrading a quality level.

### PRIOR ART DOCUMENT

Further prior art documents are JP 2006339445A, EP 1967996A1 and US 2006282189A1. EP 1967996A1 shows a factor estimating support device and method of controlling the same, and factor estimating support program. A printing device, an attachment device and a soldering device of EP 1967996A1 do not show a function that monitors the internal components (facility members) of the printing device and/or the attachment device and/or the soldering device in order to detect an abnormality operation of the internal components during the processing of a product.

Additionally, EP 1967996A1 does not show any function that records data of the internal components (facility members) and operations of the printing device and/or the attachment device and/or soldering device, wherein the data is obtained during the processing of each product.

### PATENT DOCUMENTS

Patent Document 1: Japanese Unexamined Patent Publication No. 7-38279
Patent Document 2: Japanese Unexamined Patent Publication No. 2005-156156

### SUMMARY OF THE INVENTION

### PROBLEMS TO BE SOLVED BY THE INVENTION

As described in the conventional example, when the information such as the proportion defective is presented in each member (referred to as a facility member) included in the production facility, there is a possibility of providing a clue to the estimation of a defective place. However, only the fact that many defects occur with respect to a product processed with the facility member can be recognized from the information, and a conclusive evidence whether the facility member directly causes the defect is not obtained. This is because, as to the example of the mounter, there is a possibility that another facility member except for the nozzle and cassette causes the defect or there is a possibility another process such as a solder printing process and a reflow process causes the defect.

Even if the facility member of the nozzle or the cassette causes the defect, which kind of the abnormality occurs in the facility member can hardly identified by the conventional method. Accordingly, even if the defective place is found, knowledge and experience of an expert or adjustment work depending on a trial-and-error method is required in order to uncover the actually occurring abnormality to properly take a countermeasure against the abnormality. As to the mounter, for example, even if the frequent occurrence of the defect in a certain nozzle is found, a decision such as necessity of exchange of the nozzle, washing or attaching adjustment of the nozzle, alteration of a mounting program of the mounter, and fixing of the facility member except for the nozzle can hardly be made unless what kind of the abnormality can be identified in a series of operations such as suction, movement, positioning, mounting (push-in), and releasing of a component.

An object of the present invention is to provide a technology of specifically identifying the production facility abnormality directly causing the defect, and of simplifying the maintenance and quality management of the facility.

This object is achieved by the subject matter of the independent claims 1 and 12. Further advantageous embodiments of the invention are the subject matters of the dependent claims. Aspects of the present invention are set out below.

A configuration that estimates the production facility abnormality causing the defect by analyzing the data of the observation value observed in the production facility during the processing of each product is adopted in the present invention in order to achieve the object.

Specifically, a quality management apparatus according to an aspect of the present invention performs quality management of a production line, a production facility including a function of monitoring an observation value for plural observation items in order to detect an operation abnormality of the own apparatus and an inspection apparatus that inspects a product processed with the production facility being provided in the production line, the quality management apparatus includes: an observation data acquisition unit configured to acquire the observation data in which an observation value of each observation item observed with the production facility during the processing of each product is recorded; and a causal factor estimator configured to compare the observation value during the processing of a defective to the observation value during the processing of a nondefective to determine whether the operation abnormality of the production facility occurs using the observation data, the operation abnormality being able to become a causal factor, when the inspection apparatus detects a defect in a certain product.

In the configuration, whether the production facility operation abnormality that can become the causal factor occurs is determined using the observation data that is actually observed in the production facility during the processing of the defective and nondefective, so that the direct cause of the defect detected with the inspection apparatus can specifically be identified with high accuracy. The maintenance of the production facility or the quality management of the production line is simplified when the cause is specifically identified.

The causal factor estimator may determine that the operation abnormality of the production facility associated with the observation item is the causal factor when a significant change between the observation value during the processing of the defective and the observation value during the processing of the nondefective is recognized with respect to a certain observation item. Thus, the production facility operation abnormality can be detected with high accuracy by estimating the change of the defective observation value relative to the nondefective observation value.

The causal factor estimator may consider that the significant change exists in the observation value when the observation value during the processing of the defective separates from an average of an observation value distribution during the processing of the nondefective by a predetermined distance or more. The change of the observation value can be estimated through the simple processing by the statistical technique. The predetermined distance may be n times (for example, 3σ) of a standard deviation of the observation value distribution during the processing of the nondefective.

The quality management apparatus according to the aspect of the present invention further include a storage unit which stores a table including a correspondence between an abnormal event that can occurs in the production facility and a product defect that can occur due to the abnormal event and a correspondence between the abnormal event that can occurs in the production facility and the observation item in which a change of the observation value appears when the abnormal event occurs. In this case, the causal factor estimator may extract the abnormal event of the production facility as a causal factor candidate when the defect is detected in a certain product, the abnormal event of the production facility corresponding to the defect in the table, and may estimate whether the abnormal event is the causal factor using the observation data of the observation item corresponding to the abnormal event of the causal factor candidate in the table. Instrumentation (automation) of the causal factor estimation equivalent to the judgement based on the knowledge and information of the expert can be performed using the table. Additionally, it is only necessary to refer to the tables, so that the simplification of the processing and the shortening of the processing time can be achieved.

The causal factor estimator may output information indicating a kind of the defect, information indicating the extracted causal factor candidate, and information indicating an estimation result of the causal factor. The causal factor estimator may output the observation value during the processing of the product in which the defect is detected and information about the observation value during the processing of the nondefective. When the pieces of information are provided to the user, the user can check a process of the causal factor estimating processing, and enhance understanding for the estimation result.

The causal factor estimator may output information indicating an abnormal place and the abnormal operation of the production facility with respect to the abnormal event estimated to be the causal factor. The causal factor estimator may output the information indicating the kind of the defect and the information indicating the product in which the defect is detected together with the information indicating the abnormal place and the abnormal operation of the production facility. The occurrence place and kind of the production facility abnormality can simply be identified by providing the information to the user.

The monitoring function of the production facility is a function of determining that the abnormality occurs in the operation of the production facility when the observation value of a certain observation item is out of a normal range defined by a previously-set monitoring criterion value. The quality management apparatus may further include a monitoring criterion setting unit configured to decide a new monitoring criterion value used to monitor the observation value based on the observation value distribution of a plurality of products. In this case, because of the use of the observation data actually observed in the production facility, the more valid monitoring criterion value can be expected to be set.

The monitoring criterion setting unit may output the new monitoring criterion value, automatically sets the new monitoring criterion value to the production facility, or sets the new monitoring criterion value to the production facility after permission to change the monitoring criterion value of the production facility is received from a user.

Preferably the production line is a surface mounting line for a printed circuit board, and the production facility is a mounter that mounts an electronic component on the printed circuit board. This is because, in the production facility for the surface mounting line, particularly in the mounter, plural kinds of facility members such as a nozzle, a head, a feeder, a camera, a pump, and a stage perform various operations, and it is difficult to identify which one of the operation abnormalities of the facility member causes the defect.

The present invention can be comprehended as a quality management apparatus including at least a part of the units. Further aspects of the present invention can also be comprehended as a quality management apparatus controlling method, a computer program that causes a computer to execute each step of the quality management apparatus controlling method, or a computer-readable recording medium in which the computer program is no-transitorily recorded. The present invention can be made by combining the configurations and functions as long as a technical inconsistency is not generated.

### EFFECT OF THE INVENTION

Accordingly, in the present invention, the production facility abnormality directly causing the defect can specifically be identified to simplify the maintenance and quality management of the facility.

### BRIEF DESCRIPTION OF THE DRAWINGS

Fig. 1 is a view illustrating a configuration of production facilities and quality management system in a surface mounting line.
Fig. 2 is a schematic view illustrating a configuration of a mounter according to an embodiment.
Fig. 3 is a flowchart illustrating a flow of component mounting processing of a mounter.
Fig. 4 is a view illustrating an example of a component list (mounting condition) included in a mounting program.
Fig. 5 is a view illustrating a table in which an abnormality detected with the mounter and an abnormality correction method are correlated with each other.
Fig. 6 is a functional block diagram of an analyzer.
Fig. 7 is a flowchart illustrating a flow of causal factor estimating processing of the analyzer.
Fig. 8 is a view illustrating an example of inspection data.
Fig. 9 is a view illustrating an example of observation data.
Fig. 10 is a view illustrating an example of a mounter abnormality-inspection defect table.
Fig. 11 is a view illustrating an example of a mounter abnormality-observation item table.
Fig. 12 is a view illustrating an example of a factor list.
Fig. 13 is a flowchart illustrating a flow of monitoring criterion value setting processing of the analyzer.

### MODE FOR CARRYING OUT THE INVENTION

Hereinafter, an exemplary embodiment of the present invention will be described in detail with reference to the drawings. However, the present invention is not limited to a size, a material, a shape, and a relative disposition of a component described in the embodiment unless otherwise noted.

### <System configuration>

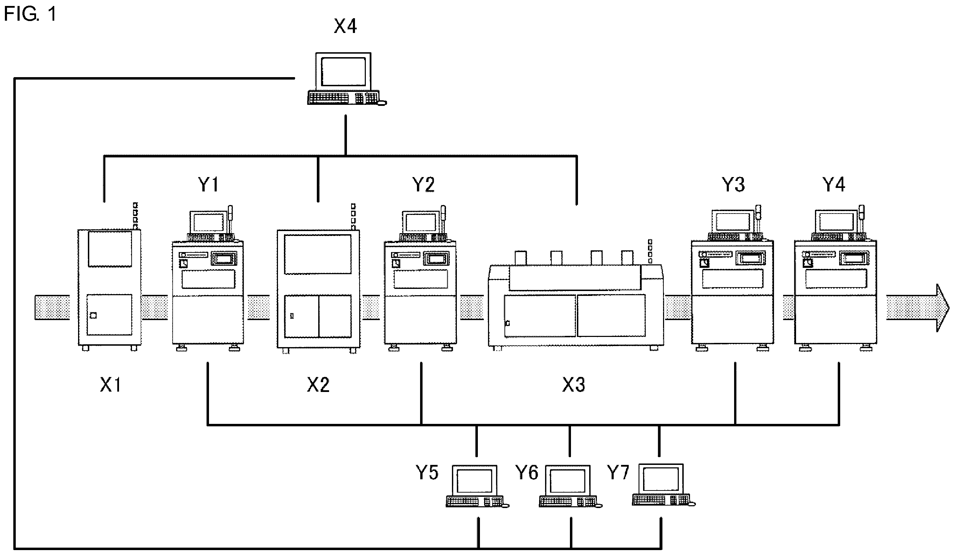

Fig. 1 schematically illustrates configuration example of production facilities and a quality management system in a surface mounting line of a printed circuit board. A Surface Mount Technology (SMT) is a technology of soldering the electronic component on the surface of the printed circuit board, and the surface mounting line is mainly constructed with three processes, namely, solder printing, component mount, and reflow (welding of solder).

As illustrated in Fig. 1, in the surface mounting line, a solder printing apparatus X1, a mounter X2, and a reflow furnace X3 are sequentially provided from an upstream side as the production facilities. The solder printing apparatus X1 is an apparatus that prints the solder paste onto an electrode portion (called a land) on a printed circuit board by the screen printing. The mounter X2 is an apparatus that picks up the electronic component to be mounted on the board and places the component on the solder paste at the corresponding point, and the mounter X2 is also called a chip mounter. The reflow furnace X3 is a heating apparatus that heats and melts the solder paste, and cools the solder paste to bond the electronic component onto the board. The production facilities X1 to X3 are connected to a production facility management apparatus X4 through a network (LAN). The production facility management apparatus X4 is a system that manages and wholly controls the production facilities X1 to X3. The production facility management apparatus X4 includes functions of storing, managing, and outputting a mounting program (including an operation procedure, a production condition, and a setting parameter) defining an operation of each production facility and log data of each production facility. The production facility management apparatus X4 also includes a function of updating the mounting program set to the corresponding production facility when an instruction to change the mounting program is received from an operator or another apparatus.

A quality management system Y is installed in the surface mounting line. The quality management system Y inspects a state of the board at an exit of each of the processes of the solder printing, the component mount, and the reflow, and automatically detects the defect or a risk of the defect. In addition to a function of automatically sorting the nondefective and defective, the quality management system Y has a function (for example, the change of the mounting program) of performing feedback to the operation of each production facility on the basis of the inspection result or an analysis result of the inspection result. As illustrated in Fig. 1, the quality management system Y of the first embodiment includes four kinds of inspection apparatuses, an inspection management apparatus Y5, an analyzer Y6, and a workstation Y7. The four kinds of inspection apparatuses includes a solder printing inspection apparatus Y1, a component inspection apparatus Y2, an appearance inspection apparatus Y3, and an X-ray inspection apparatus Y4.

The solder printing inspection apparatus Y1 is an apparatus that inspects the state of the solder paste printed on the board carried out from the solder printing apparatus X1. In the solder printing inspection apparatus Y1, the solder paste printed on the board is two-dimensionally or three-dimensionally measured, whether each kind of an inspection item is a normal value (permissible range) is determined from a measurement result. Examples of the inspection items include a volume, an area, a height, misregistration, and a shape of the solder. An image sensor (camera) can be used in the two-dimensional measurement of the solder paste, and a laser displacement meter, a phase shift method, a spatial coding method, and a photo cutting method can be adopted in the three-dimensional measurement.

The component inspection apparatus Y2 is an apparatus that inspects a disposition state of the electronic component with respect to the board carried out from the mounter X2. In the component inspection apparatus Y2, the component (component body or such a part of the component as an electrode (lead)) placed on the solder paste is two-dimensionally or three-dimensionally measured, whether each kind of the inspection item is the normal value (permissible range) is determined from the measurement result. Examples of the inspection items include the misregistration and angle (rotation) deviation of the component, shortage (the component is not disposed), a wrong component (a wrong component is disposed), wrong polarity (the component side and the board side differ from each other in an electrode polarity), reversal (the component is reversely disposed), and a component height. Similarly to the solder printing inspection, the image sensor (camera) can be used in the two-dimensional measurement of the electronic component, and the laser displacement meter, the phase shift method, the spatial coding method, and the photo cutting method can be adopted in the three-dimensional measurement.

The appearance inspection apparatus Y3 is an apparatus that inspects a soldering state of the board carried out from the reflow furnace X3. In the appearance inspection apparatus Y3, the post-reflow soldered portion is two-dimensionally or three-dimensionally measured, whether each kind of the inspection item is a normal value (permissible range) is determined from a measurement result. In addition to the same inspection items as the component inspection, the nondefective of defective of a solder fillet shape is also included in the inspection item. What is called a color highlight method (a soldering surface is irradiated with R, G, and B illuminations at different incident angles, and reflected light of each color is photographed with a zenith camera, whereby the three-dimensional shape of the solder is detected as two-dimensional hue information) can be adopted as the measurement of the solder shape in addition to the laser displacement meter, the phase shift method, the spatial coding method, and the photo cutting method.

The X-ray inspection apparatus Y4 is an apparatus that inspects the soldered state of the board using an X-ray image. For a package component such as a BGA (Ball Grid Array) and a CSP (Chip Size Package) or a multilayer board, because the solder bonding portion is hidden behind the component or board, the appearance inspection apparatus Y3 can hardly inspect the soldered state (that is, the soldered state is hardly inspected in the appearance image). The X-ray inspection apparatus Y4 is an apparatus that complements a weak point of the appearance inspection. Examples of the inspection items of the X-ray inspection apparatus Y4 include the misregistration of the component, the solder height, the solder volume, a diameter of a solder ball, the back fillet length, and the nondefective and defective of the solder bonding. An X-ray transmission image may be adopted as the X-ray image, or preferably a CT (Computed Tomography) image is also used.

The inspection apparatuses Y1 to Y4 are connected to the inspection management apparatus Y5 through the network (LAN). The inspection management apparatus Y5 is a system that manages and wholly controls the inspection apparatuses Y1 to Y4. The inspection management apparatus Y5 includes functions of storing, managing, and outputting an inspection program (including an operation procedure, an inspection condition, and a setting parameter) defining operations of the inspection apparatuses Y1 to Y4 and the inspection results or pieces of log data obtained with the inspection apparatuses Y1 to Y4.

The analyzer Y6 is a system that includes a function of performing prediction or factor estimation of the defect by analyzing the inspection results (the inspection results of the processes) of the inspection apparatuses Y1 to Y4, the inspection results of the inspection apparatuses Y1 to Y4 being aggregated into the inspection management apparatus Y5, and a function of performing the feedback (such as the change of the mounting program) to each of the production facilities X1 to X3 as needed basis.

The workstation Y7 is a system that includes a function of displaying pieces of information about the states of the production facilities X1 to X3, the inspection results of the inspection apparatuses Y1 to Y4, and the analysis result of the analyzer Y6, a function of changing (editing) the mounting program and inspection program of the production facility management apparatus X4 and inspection management apparatus Y5, and a function of checking an operating situation of the whole surface mounting line.

Each of the production facility management apparatus X4, the inspection management apparatus Y5, and the analyzer Y6 can be constructed with a general-purpose computer system including a CPU (Central Processing Unit), a main storage device (memory), an auxiliary storage device (such as a hard disk), an input device (such as a keyboard, a mouse, a controller, and a touch panel), and a display. The apparatuses X4, Y5, and Y6 can be separately be provided, all the functions of the apparatuses X4, Y5, and Y6 can be implemented in one computer system, or a part of or all the functions of the apparatuses X4, Y5, and Y6 can be implemented in a computer included in one of the production facilities X1 to X3 and the inspection apparatuses Y1 to Y4. Although the networks of the production facilities and quality management system are individually illustrated in Fig. 1, a network having any configuration can be used as long as data communication can be conducted between the production facilities and the quality management system.

### <Mounter>

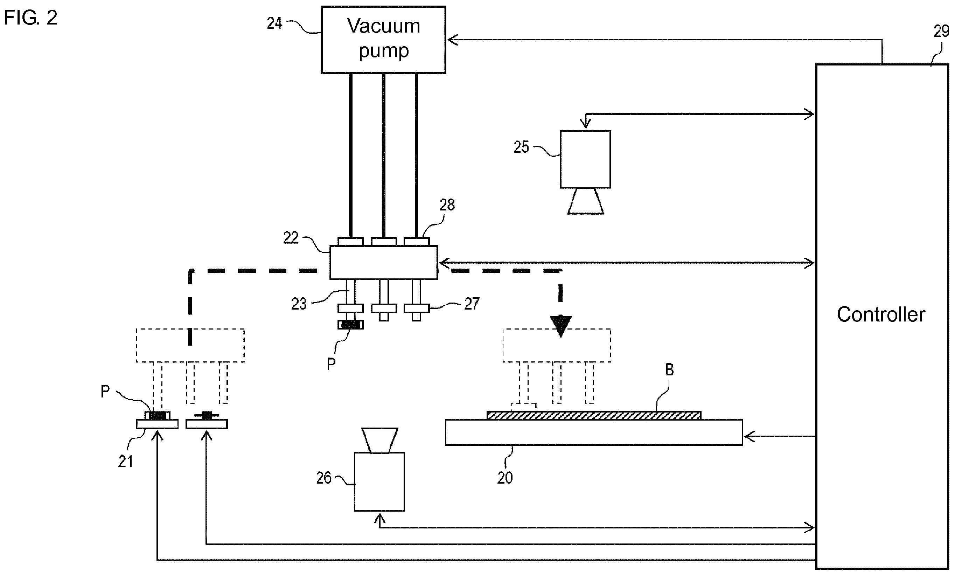

A configuration of the mounter X2 of the embodiment will be described in detail with reference to Fig. 2. Fig. 2 is a schematic diagram illustrating a configuration of apparatus members included in the mounter.

The mounter X2 includes a stage 20 on which a board B is placed, plural feeders 21 that supply electronic components P, a movable head 22 that picks up the electronic component P, plural nozzles 23 attached to the head 22, and a vacuum pump 24 that controls an air pressure of each nozzle. The components P having different product numbers are set in the feeders 21 of each line. The mounter X2 also includes an upper camera 25, a lower camera 26, a contact sensor 27 that measures a contact pressure at an end surface of the nozzle, and a pressure sensor 28 that measures the air pressure of the nozzle as an observation system that detects the abnormality of the own quality management system. A controller 29 is a block that performs control of each part of the mounter X2, a calculation, and information processing. The controller 29 includes a CPU (Central Processing Unit) and a memory.

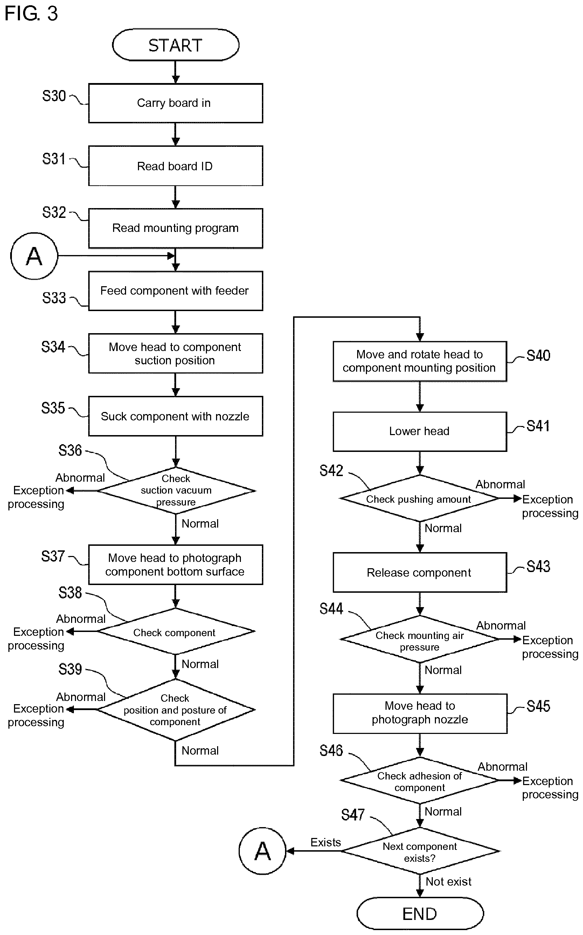

Fig. 3 is a flowchart illustrating a flow of component mounting processing of the mounter X2.

The controller 29 controls the stage 20 to carry the target board B in, and to position the board B at a predetermined position (Step S30). The board B is photographed with the upper camera 25, and the controller 29 reads a board ID printed in or adhering to the board B from an image of the board B (Step S31).

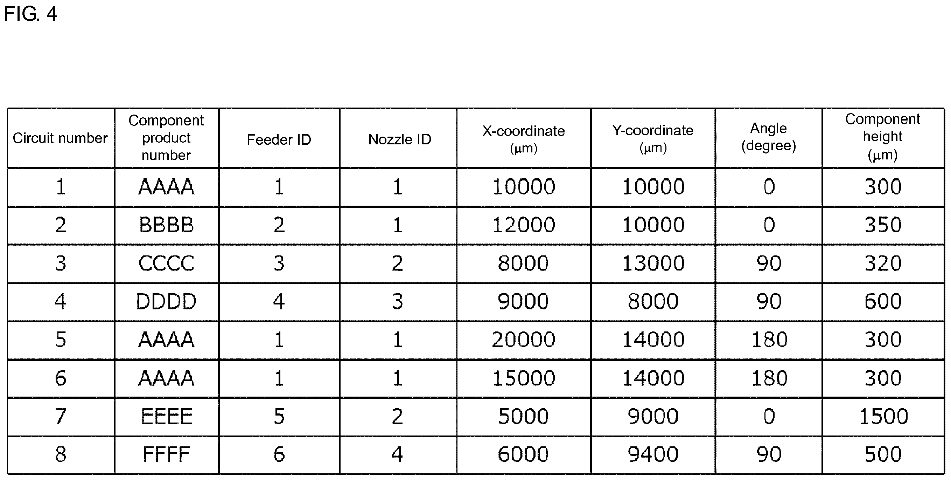

The controller 29 reads a mounting program corresponding to the board B (Step S32). Fig. 4 illustrates an example of a component list included in the mounting program. Each line of the list expresses a mounting condition of one component. Pieces of information such as a circuit number on the board that becomes a component mounting destination, the product number of the component, an ID of the feeder 21 that supplies the component, an ID of the nozzle 23 that picks up the component, an X-coordinate and a Y-coordinate of the component mounting position, a rotation angle in mounting the component, and a height of the component are defined in the mounting condition. In addition to the list in Fig. 4, an operating procedure of the mounter X2, a monitoring criterion used in an operation abnormality determination, and various setting parameters are included in the mounting program.

A mounting sequence performed by the mounter X2 will be described below with the component in a first line of the list as an example.

### (1) Component feeding

The controller 29 controls the feeder 21 having the ID of 1 to feed the component having the product number of AAAA to a predetermined component suction position (Step S33).

### (2) Component suction

The controller 29 controls the head 22 to move the nozzle 23 having the ID of 1 to the component suction position, and to lower the nozzle 23 until a tip of the nozzle 23 comes into contact with a component top surface (Step S34). The contact between the tip of the nozzle and the component is detected by output (contact pressure) of the contact sensor 27 provided in the nozzle 23 having the ID of 1.

The controller 29 controls the vacuum pump 24 to decrease the air pressure of the nozzle 23 having the ID of 1, and to suck the component (Step S35). At this point, the controller 29 observes a suction vacuum pressure with the pressure sensor 28 provided in the nozzle 23 having the ID of 1, and checks whether the suction vacuum pressure is lower than a monitoring criterion value (Step S36). When the suction vacuum pressure is lower than the monitoring criterion value (normal), an observation value of the suction vacuum pressure is recorded in a memory, and the flow goes to next processing. On the other hand, when the suction vacuum pressure exceeds the monitoring criterion value (abnormal), the mounting processing is interrupted to perform exception processing. This is because the occurrence of the defect caused by a suction error or a suction deficiency is prevented before it happens. The detailed exception processing is described later.

### (3) Component recognition

The controller 29 controls the head 22 to move the component to a position above the lower camera 26, and to photograph a bottom surface of the component with the lower camera 26 (Step S37).

The controller 29 checks whether the component sucked with the nozzle 23 is the component having the product number of AAAA through image recognition processing (Step S38). Specifically, an external shape of the component in the image is recognized, and compared to model data of the component having the product number of AAAA previously stored in the memory, thereby calculating a component concordance rate. Then, whether the component in the image is identical to the component having the product number of AAAA is determined on the basis of whether the component concordance rate is higher than the monitoring criterion value (normal). When the component in the image is determined to be identical to the component having the product number of AAAA, the component concordance rate is recorded in the memory, and the flow goes to the next processing. On the other hand, when the component in the image is not identical to the component having the product number of AAAA (abnormal), the mounting processing is interrupted to perform the exception processing. This is because the mounting of a different kind of component is prevented. The detailed exception processing is described later.

The controller 29 checks the position and posture of the component sucked by the nozzle 23 through the image recognition processing (Step S39). For example, when the nozzle 23 deviates from a center of the component during the component suction due to distortion of the feeder, a misalignment or a rotation deviation occurs in the component. In order to correct the deviation amounts in mounting the component, a misalignment amount (X,Y) and a rotation deviation amount (θ) are calculated in Step S39. When the misalignment amount and the rotation deviation amount are smaller than the monitoring criterion value (normal), the misalignment amount and the rotation deviation amount are recorded in the memory, and the flow goes to the next processing. On the other hand, the misalignment amount and the rotation deviation amount exceed the monitoring criterion value (abnormal), the mounting processing is interrupted to perform the exception processing. This is because a probability that the abnormality occurs in the feeder increases when the deviation amount is excessively large. The detailed exception processing is described later.

### (4) Component mounting

The controller 29 controls the head 22 to move and rotate the component according to the component mounting position and angle (X: 10000 µm, Y: 10000 µm, and θ: 0 degree) provided by the mounting condition (Step S40). At this point, the misalignment amount and rotation deviation amount obtained in Step S39 are also corrected.

Then, the controller 29 lowers the head 22 until a gap between the tip of the nozzle 23 and the board top surface agrees with the component height (h: 300 µm) provided by the mounting condition (Step S41). At this point, the controller 29 observes the output of the contact sensor 27 while lowering the head 22, whereby a height is detected at a time point the bottom surface of the component comes into contact with the solder, and a pushing amount of the component from the height is observed (Step S42). When the pushing amount falls within a normal range defined by the monitoring criterion value, the pushing amount is recorded in the memory, and the flow goes to the next processing. On the other hand, when the pushing amount is out of the normal range (abnormal), the mounting processing is interrupted to perform the exception processing. This is because there is a risk that the defect occurs during the reflow when the pushing amount is improper. The detailed exception processing is described later.

When the head 22 is lowered to a predetermined height, the controller 29 controls the vacuum pump 24 to increase the air pressure of the nozzle 23, and to release the component from the nozzle 23 (Step S43). At this point, the controller 29 observes a mounting air pressure with the pressure sensor 28 to check whether the mounting air pressure falls within a normal range between a monitoring criterion value (lower limit) and a monitoring criterion value (upper limit) (Step S44). When the mounting air pressure falls within the normal range, the observation value is recorded in the memory, and the flow goes to the next processing. On the other hand, when the mounting air pressure is out of the normal range, the mounting processing is interrupted to perform the exception processing. This is because there is a possibility that the excessive mounting air pressure leads to the component deviation or a possibility that the component is not separated from the nozzle due to the deficiency of the mounting air pressure. The detailed exception processing is described later.

### (5) Checking of take-away

After the mounting of the component, the controller 29 moves the nozzle 23 to the position above the lower camera 26 to performs the photographing with the lower camera 26 (Step S45), and checks whether the component keeps adhering to the nozzle 23 through the image recognition processing (Step S46). When the component adheres to the nozzle 23, the mounting processing is interrupted to perform the exception processing. When the component does not adhere to the nozzle 23, the controller 29 returns the head 22 to a starting position, and repeats the pieces of processing (Steps S33 to S46) with respect to the next component (Step S47). The mounting sequence for one component is described in the embodiment. Alternatively, different components are picked up with plural nozzles, and the plural components may be mounted by one-time sequence.

For example, the data of the observation value observed and recorded during the component mounting processing is stored in the production facility management apparatus X4 as log data in timing of ending the processing of one component, timing of ending the processing of one board, or predetermined timing such as a given time interval.

### <Self-diagnosis function>

As described above, the mounter X2 of the embodiment includes a self-diagnosis function of always monitoring the operation of the own quality management system with the observation system such as the camera and the sensor, and of interrupting the mounting processing to perform the predetermined exception processing when the observation value is out of the predetermined monitoring criterion value (that is, when the abnormal operation is recognized).

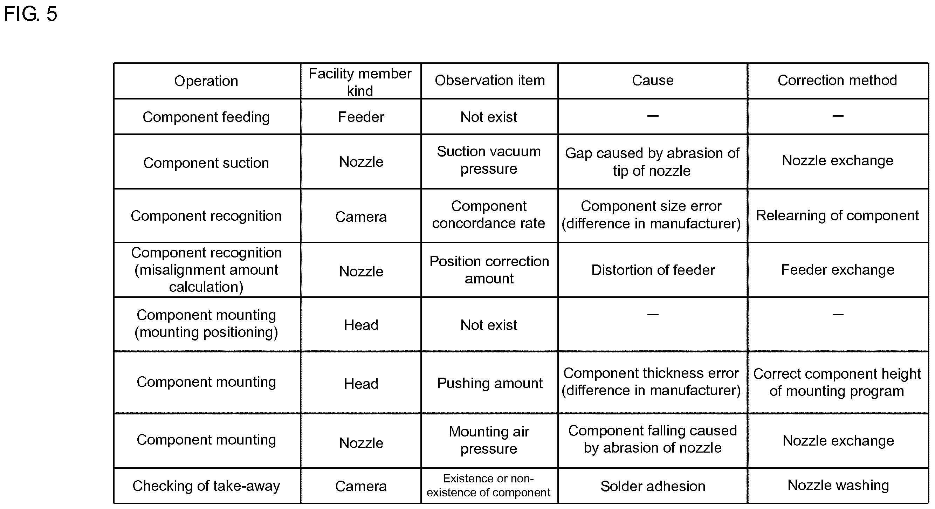

Fig. 5 illustrates a table in which the abnormality detected with the mounter X2 and an abnormality correction method are correlated with each other. The table is provided from the production facility management apparatus X4 or previously stored in the memory of the controller 29. In the table, the correction method corresponds to each combination of the facility member, operation, and observation item of the mounter X2. Although the correction method also corresponds to the factor in the example of Fig. 5, the information about the factor may be omitted.

For example, it is assumed that the suction vacuum pressure of the nozzle 23 having the ID of n exceeds the monitoring criterion value in Step S36 of Fig. 3. This abnormality causes a suction error component or a suction deficiency to lead to a probability of the occurrence of the defect such as component falling, component deviation, and missing product. The most frequent cause of the increase in suction vacuum pressure is generation of a gap between the nozzle and the component due to abrasion of the tip of the nozzle. Exchange of the nozzle having the ID of n is a proper correction method for solving the problem. The controller 29 outputs a message that "Exchange the nth nozzle for new one because the nth nozzle is abraded." as the exception processing to notify an operator of the cause of the abnormality and a countermeasure against the abnormality. Therefore, even a person who is not an expert can quickly and properly perform the maintenance. The message may be output from the mounter X2, or other apparatuses such as the production facility management apparatus X4, the analyzer Y6, and the workstation Y7. Any message outputting method such as display of the message on a monitor, printing with a printer, sound output from a speaker, and email transmission may be adopted.

### <Analyzer>

The causal factor estimating processing and monitoring criterion value setting processing, which are performed by the analyzer Y6, will be described below. The causal factor estimating processing is processing of specifically identifying the production facility abnormality directly causing the defect in the case that the defect is detected with the inspection apparatus. The monitoring criterion value setting processing is processing of narrowing down the monitoring criterion value used in the self-diagnosis function of the production facility to a better value on the basis of the inspection result of the inspection apparatus. An example in which the inspection result is applied to the abnormal identification of the mounter X2 or update of the monitoring criterion value will be described below.

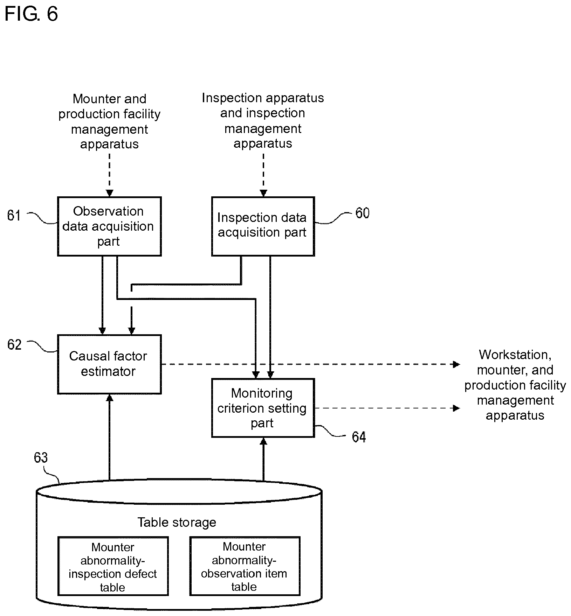

Fig. 6 is a functional block diagram of the analyzer Y6. The analyzer Y6 includes functions of an inspection data acquisition part 60, an observation data acquisition part 61, a causal factor estimator 62, a table storage 63, and a monitoring criterion setting part 64. (The CPU of) the analyzer Y6 executes a computer program to implement these functions. In all the functions included in the analyzer Y6, only functions associated with the causal factor estimating processing and monitoring criterion value setting processing are illustrated in Fig. 6, and other functions are not illustrated.

### (1) Causal factor estimating processing

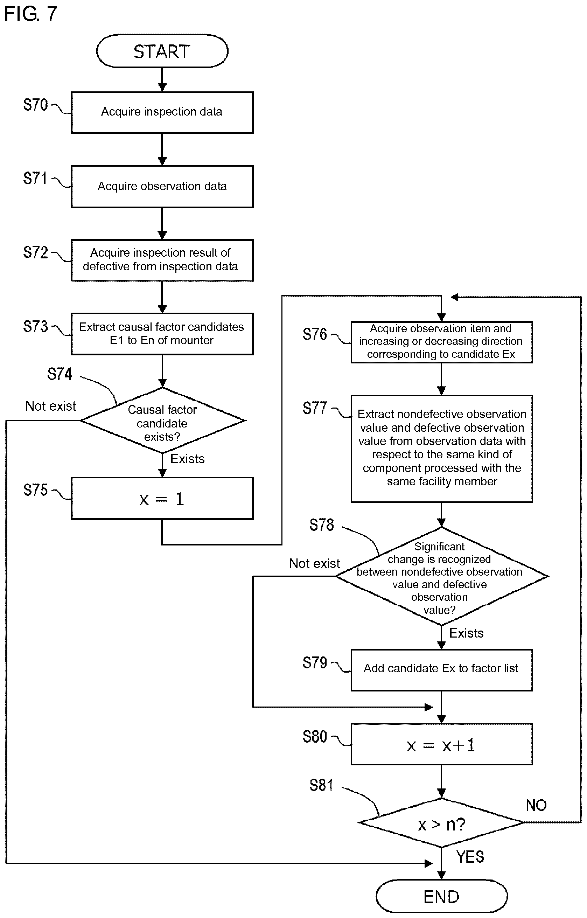

Fig. 7 is a flowchart illustrating a flow of the causal factor estimating processing of the analyzer Y6. The causal factor estimating processing is performed on a predetermined starting condition (for example, when the number of components determined to be defective is larger than a specified value, when the proportion defective is larger than a specified value, or when an operator inputs a starting command).

The inspection data acquisition part 60 acquires data (referred to as inspection data) of the inspection result obtained with the inspection apparatus (Step S70). The inspection data acquisition part 60 may directly acquire the inspection data from each of the inspection apparatuses Y1 to Y4, or read the inspection data collected in the inspection management apparatus Y5. All the accumulated pieces of inspection data may be read, or only a part of the pieces of inspection data (for example, only the data accumulated after the previous processing or only the data in a period specified by the operator) may be read. A result of a post-printing inspection performed with the solder printing inspection apparatus Y1, a result of a post-mounting inspection performed with the component inspection apparatus Y2, and a result of a post-reflow inspection performed with the appearance inspection apparatus Y3 and X-ray inspection apparatus Y4 are included in the inspection data. In the embodiment, only the pieces of inspection data of the post-mounting inspection and post-reflow inspection are used in order to determine whether the mounter X2 is abnormal.

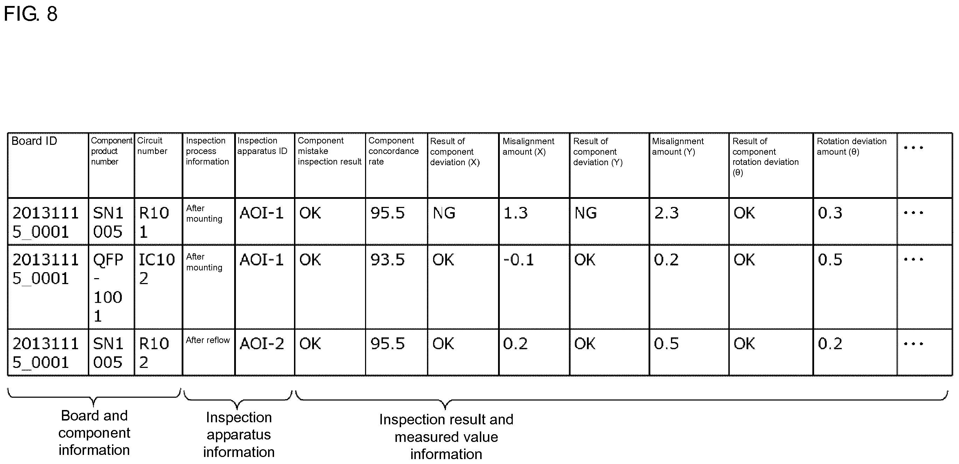

Fig. 8 illustrates an example of the inspection data. The inspection data includes "board and component information" such as the board ID, the component product number, and the circuit number, "inspection apparatus information" such as inspection process information and an inspection apparatus ID, and "inspection result and measured value information" associated with plural inspection items. The inspection result and measured value information is a pair of a measured value that is of an index measured from the component in the inspection and the inspection result that is of a determination result of OK (nondefective) / NG (defective) on the basis of the measured value.

Then, the observation data acquisition part 61 acquires data (referred to as observation data) of the observation value observed with the mounter X2 (Step S71). The observation data acquisition part 61 may directly acquire the observation data from the mounter X2, or acquire the observation data collected in the production facility management apparatus X4. At this point, all the pieces of observation data of the board and component, which are identical to those of the inspection data acquired in Step S70, are acquired.

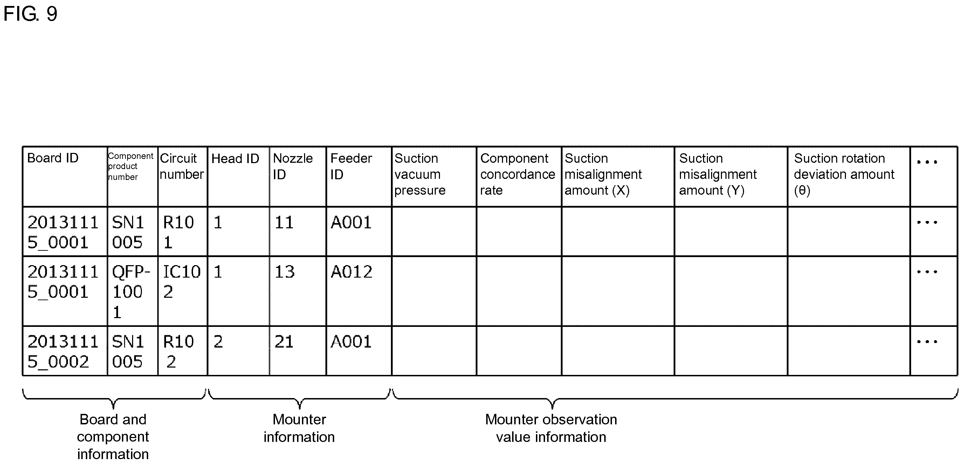

Fig. 9 illustrates an example of the observation data. The observation data includes the "board and component information" such as the board ID, the component number, and the circuit number, "mounter information" such as the head ID, the nozzle ID, and the feeder ID, and "mounter observation value information" such as the suction vacuum pressure, the component concordance rate, the suction misalignment amount (X), the suction misalignment amount (Y), the suction rotation deviation amount (θ), the pushing amount, and the mounting air pressure.

Then, the causal factor estimator 62 acquires data of component (referred to as a defective) determined to be defective from the inspection data (Step S72). In the case that the data of the component having the different circuit number is included in the plural acquired pieces of defective data, the following pieces of processing may be performed in each circuit number. In the embodiment, assuming that the defect of "component deviation" is detected in some components having the identical circuit number, the following description will be made.

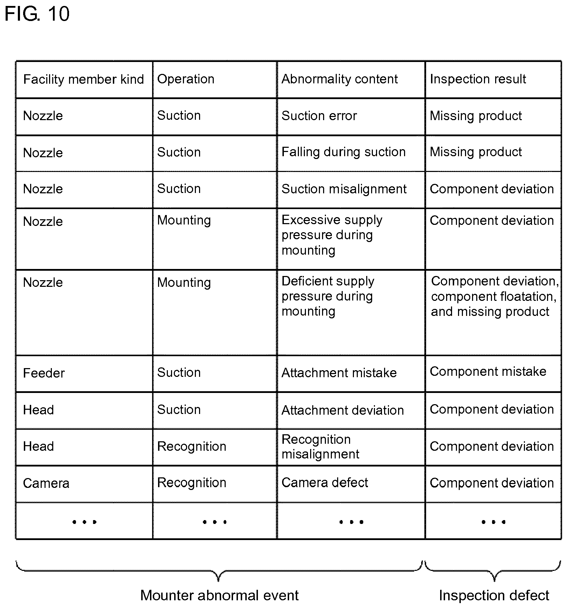

Then, the causal factor estimator 62 refers to a "mounter abnormality-inspection defect table" stored in the table storage 63, and selects an abnormal event of the mounter X2, which can become the cause of the defect (component deviation) detected in Step S72, as causal factor candidates E1 to En (Step S73). The mounter abnormality-inspection defect table is a table (knowledge base) defining correspondence between the abnormal event that can occur in the mounter X2 and a product defect that can occur due to the abnormal event. As illustrated in Fig. 10, the abnormal event of the mounter X2 is defined by a set of a "facility member kind", the "operation", and an "abnormal content", and a defect kind (a name of the inspection item) is correlated with each abnormal event. Plural kinds of defects may be correlated with one abnormal event. In the embodiment, plural abnormal events such as "suction misalignment in nozzle suction operation", "excessive supply pressure during mounting in nozzle mounting operation", ..., and "camera defect in camera recognition operation" are extracted as the causal factor candidate corresponding to the "component deviation". When the defect corresponding to the defect detected in Step S72 does not exist in the mounter abnormality-inspection defect table, it is considered that the cause of the defect does not exist in the mounter X2. Therefore, the processing is ended (Step S74).

After a variable x is initialized as 1 (Step S75), the following pieces of processing are performed on the causal factor candidate Ex (x = 1 to n).

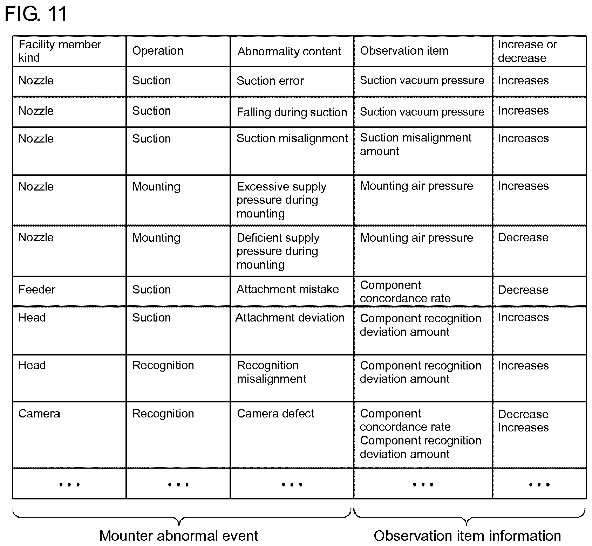

First, the causal factor estimator 62 refers to a "mounter abnormality-observation item table" stored in the table storage 63, and checks an observation item corresponding to the causal factor candidate Ex and an increasing or decreasing direction of the observation value (Step S76). The mounter abnormality-observation item table is a table (knowledge base) defining correspondence between the abnormal event that can occur in the mounter X2 and the observation item in which the observation value changes (increases or decreases) when the abnormal event occurs. As illustrated in Fig. 11, the abnormal event of the mounter X2 is defined by a set of the "facility member kind", the "operation", and the "abnormal content", and the observation item and the increasing or decreasing direction of the observation value are correlated with each abnormal event. For example, as to the abnormal event of the "excessive supply pressure during mounting in nozzle mounting operation" that is of the causal factor candidate E2, it is found that the observation value abnormality of the "increase in mounting air pressure" is recognized. The two tables in Figs. 10 and 11 may gather into one table.

Then, the causal factor estimator 62 extracts the observation value of the observation item corresponding to the causal factor candidate Ex from the pieces of observation data. At this point, not only the observation value (hereinafter, simply referred to as a "defective observation value ") in mounting the defective, but also the observation value (hereinafter, simply referred to as a "nondefective observation value") in mounting the nondefective, which is processed with the same facility member while having the same number as the defective, are extracted (Step S77). The causal factor estimator 62 compares the extracted nondefective observation value and defective observation value to each other to estimate whether a significant change is recognized between the nondefective observation value and the defective observation value (Step S78). When the significant change is recognized, namely, when the abnormality is recognized in the defective observation value (YES in Step S78), the causal factor candidate Ex is determined to be the causal factor (one of the causal factors), and is added to a factor list (Step S79). On the other hand, when the significant change is recognized (NO in Step S78), the causal factor candidate Ex is determined not to be the causal factor.

Any method may be adopted in order to determine whether the significant change is recognized between the nondefective observation value and the defective observation value. For example, in the case that the defective observation value is separated from an average of a nondefective observation value distribution by a predetermined distance, it is considered that the significant change occurs in the observation value. The "predetermined distance" used in the determination can arbitrarily be set. For example, n times (the value of n depends on a required quality standard) of the standard deviation σ of the nondefective observation value distribution may be adopted. The use of the statistical technique can estimate the change of the defective observation value relative to the nondefective observation value distribution through the simple processing.

In the embodiment, a determination is made using 3σ. That is, using plural nondefective observation values, an average A and the standard deviation σ of the nondefective observation values are calculated. In the case that at least one defective observation value v satisfying the following condition exists, it is considered that the significant change exists between the nondefective observation value and the defective observation value.
- In the case that the increasing or decreasing direction is "increase":
   v > A + 3σ
- In the case that the increasing or decreasing direction is "decrease":v < A - 3σ

In the case that the observation value changes in the opposite direction to the increasing or decreasing direction defined in the table, the change may be ignored (as no relationship with the abnormality of the mounter).

The variable x is incremented to repeat the pieces of processing in Steps S76 to S79. When the analysis is completed with respect to all the causal factor candidates E1 to En, the processing is ended (Steps S80 and S81).

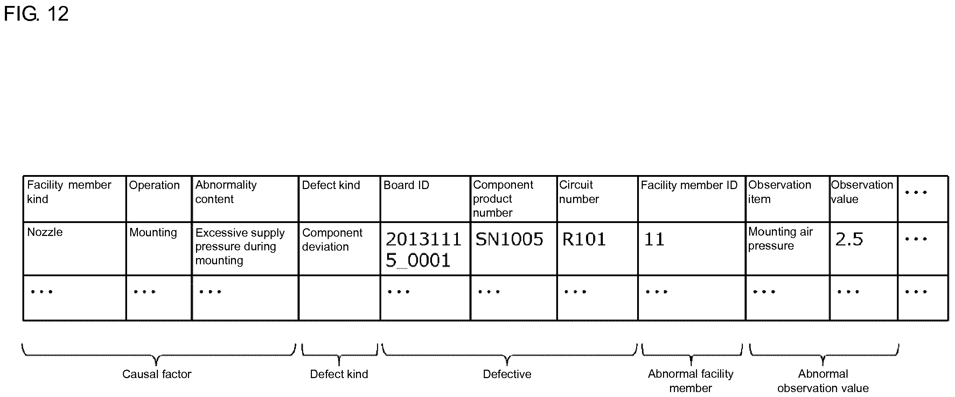

A factor list, in which the abnormal events of the mounter X2 considered to be the direct cause of the defect are described, is generated through the above pieces of processing. Fig. 12 illustrates an example of the factor list. In the example of Fig. 12, it is found that the abnormal event of "excessive supply pressure during mounting in nozzle mounting operation" is identified as the causal factor. A defect kind, defective board and component information, the ID of the facility member in which the abnormality is recognized, and the observation value in which the abnormality is recognized are also recorded in the factor list. When the causal factor is identified, for example, a message of "The defect (component deviation) is caused by the excessive supply pressure during mounting of the nth nozzle of the mounter." is displayed on a monitor, whereby the information in which the abnormal place (the facility member in which the abnormality occurs) and the abnormal operation are specifically identified can be provided to the operator. A message of "The defect (component deviation) is caused by the excessive supply pressure during mounting of the nth nozzle of the mounter. Exchange the nth nozzle for new one because the nth nozzle is abraded." is displayed on the monitor by referring to the table in Fig. 5, which allows the abnormality correction method to be presented to the operator. Therefore, even a person who is not an expert can quickly and properly perform the maintenance. The message may be output from the monitor included in the analyzer Y6 or the monitors included in other apparatuses such as the workstation Y7. The output of the message is not limited to the display of the message on the monitor, but other methods such as printing with a printer, sound output from a speaker, and email transmission may be adopted.

Preferably the causal factor estimator 62 outputs the pieces of information such as the defect kind detected in Step S72, the list of the causal factor candidates E1 to En extracted in Step S73, and the causal factor (estimation result) identified in Step S79. At this point, the pieces of information (such as the observation value distribution, the average, and the variance) about the nondefective and defective observation values extracted in Step S77 and the information indicating the difference between the nondefective and defective observation values may further be output. When the pieces of information are provided to the user, the user can check a process of the causal factor estimating processing, and enhance understanding for the estimation result. As to the information outputting method, any method such as the display of the message on the monitor, the printing with the printer, the sound output from the speaker, and the email transmission may be adopted.

### (2) Monitoring criterion value setting processing

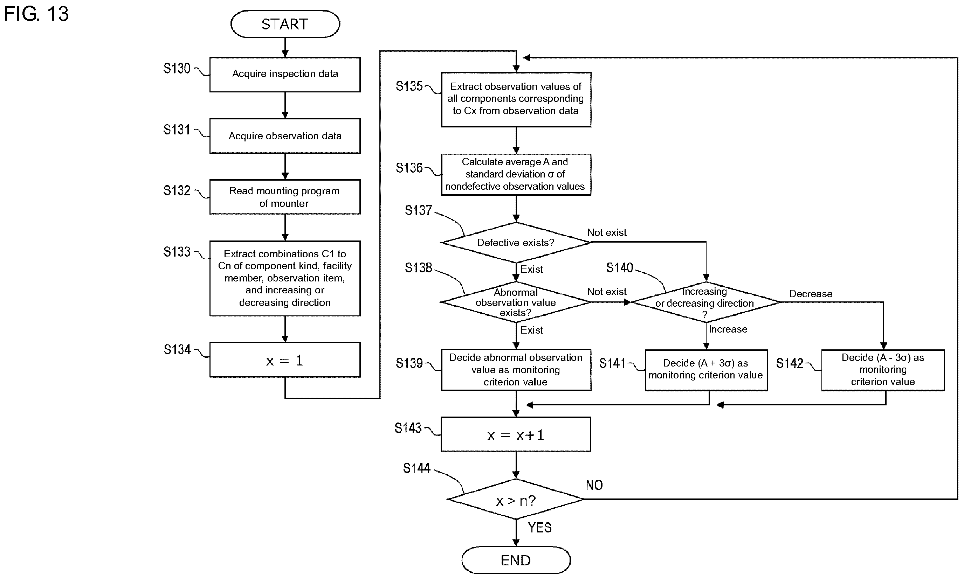

Fig. 13 is a flowchart illustrating a flow of the monitoring criterion value setting processing of the analyzer Y6. The monitoring criterion value setting processing is performed on a predetermined starting condition (for example, when the number of components determined to be defective is larger than a specified value, when the proportion defective is larger than a specified value, or when an operator inputs a starting command).

First, the inspection data acquisition part 60 acquires the inspection data (Step S130), and the observation data acquisition part 61 acquires the observation data (Step S131). The pieces of processing in Steps S130 and S131 are identical to those in Steps S70 and S71 of Fig. 7.

Then the monitoring criterion setting part 64 reads the mounting program of the mounter X2 (Step S132). The monitoring criterion setting part 64 refers to the component list (Fig. 4) included in the mounting program and the "mounter abnormality-observation item table" in the table storage 63, and produces all ways of combinations C1 to Cn of the component kind (product number), the facility member, the observation item, and the increasing or decreasing direction of the observation value (Step S133). For example, the combinations such as "product number of AAAA + nozzle having ID of 1 + suction vacuum pressure + increase", "product number of AAAA + nozzle having ID of 1 + component position deviation amount + increase", "product number of AAAA + feeder having ID of 1 + component concordance rate + decrease" are obtained. The monitoring criterion value is set in each combination.

After the variable x is initialized as 1 (Step S134), the following pieces of processing are performed on each combination Cx (x = 1 to n).

First, the monitoring criterion setting part 64 extracts the observation value of the component corresponding to the combination Cx from the pieces of observation data (Step S135). For example, the suction vacuum pressure that is observed when the component having the product number of AAAA is sucked with the nozzle having ID of 1 is extracted for "Cx = "product number of AAAA + nozzle having ID of 1 + suction vacuum pressure + increase".

Then, the monitoring criterion setting part 64 calculates the average A and standard deviation σ of the observation values of the corresponding components extracted in Step S135 (Step S136). In the case that the defective exists in the corresponding components, the defective observation value is excluded, and the average A and standard deviation σ are calculated using only the nondefective observation values (that is, the nondefective distribution) .

The following pieces of processing depend on whether the defective exists in the corresponding components (Step S137).

### (The case that the defective exists)

The monitoring criterion setting part 64 compares the defective observation value to the nondefective observation value to estimate whether the abnormality is recognized in the defective observation value (Step S138). At this point, the abnormality determination can be made by the same method as that in Step S78 of Fig. 7. That is, the defective observation value v is determined to be the abnormal value when satisfying the following condition.
- In the case that the increasing or decreasing direction is "increase": v > A + 3σ
- In the case that the increasing or decreasing direction is "decrease": v < A - 3σ

When the observation value v is determined to be the abnormal value, the observation value v is decided as a new monitoring criterion value for the observation item (Step S139). In the case that plural observation values v determined to be the abnormal value exist, the abnormal observation value v closest to the average A of the nondefective distribution may be set to the monitoring criterion value. The processing goes to Step S140 in the case that the abnormal value is not detected in Step S138.

### (The case that the defective does not exist)

The monitoring criterion setting part 64 sets 3σ of the nondefective distribution to the monitoring criterion value. That is, when the increasing or decreasing direction defined by the combination Cx is "increase" (Increase in Step S140), the value of (A + 3σ) is set to the monitoring criterion value (Step S141). On the other hand, when the increasing or decreasing direction is "decrease" (Decrease in Step S140), the value of (A - 3σ) is set to the monitoring criterion value (Step S142).

The variable x is incremented to repeat the pieces of processing in Steps S135 to S142. When the monitoring criterion value is decided with respect to all the combinations C1 to Cn, the processing is ended (Steps S143 and S144).

The monitoring criterion value is properly decided by the above method on the basis of the observation data of the mounter X2 and the inspection data of each inspection apparatus. The monitoring criterion setting part 64 may output the information about the decided monitoring criterion value to the monitor of the analyzer Y6 or workstation Y7 to encourage the operator to correct the mounting program of the mounter X2, or automatically set (rewrite) the mounting program stored in the mounter X2 or production facility management apparatus X4. Preferably, before the setting (rewrite) of the mounting program, the operator is asked whether the update is performed by displaying "The monitoring criterion value is updated?" on the monitor of the analyzer Y6 or workstation Y7, and the mounting program setting processing is performed after permission to update the monitoring criterion value is received from the user. Therefore, even a person who is not an expert can update the monitoring criterion value used in the self-diagnosis function of the mounter X2 to a more proper value, and "over-detected" or "overlooking" of the abnormality can be eliminated as much as possible. The information output method is not limited to the display of the message on the monitor, but other methods such as the printing with the printer, the sound output from the speaker, and the email transmission may be adopted.

### <Advantages of the embodiment

In the configuration of the embodiment, whether the mounter operation abnormality that can become the causal factor occurs is determined using the observation data that is actually observed in the mounter during the processing of the defective and nondefective, so that the direct cause of the defect detected with the inspection apparatus can specifically be identified with high accuracy. Because the specific cause is identified, the maintenance or quality management of the mounter is simplified.

In the embodiment, the instrumentation (automation) of the causal factor estimation equivalent to the judgement based on the knowledge and information of the expert can be performed using the tables in Figs. 10 and 11. Additionally, it is only necessary to refer to the tables, so that the simplification of the processing and the shortening of the processing time can be achieved.

The function of updating the monitoring criterion value of each observation item using the observation data is provided, so that the monitoring criterion value can automatically be narrowed down to a more valid monitoring criterion value with little over-detected or overlooking.

### <Others>

The descriptions of the above embodiment are only illustrative, and the present invention is not limited to the specific embodiment. Various modifications can be made without departing from the technical idea of the present invention.

In the embodiment, by way of example, the analyzer Y6 performs the processing of identifying the abnormality of the mounter X2 or updating the monitoring criterion value. However, the method of the present invention can be applied to the abnormality identification of other production facilities such as the solder printing apparatus X1 and the reflow furnace X3 or the update of the monitoring criterion value. Additionally, the method of the present invention is not limited to the surface mounting line, and the method can suitably be applied to the quality management of any kind of production line as long as the production line includes the production facility and the inspection apparatus.

When the defective does not exist in the component corresponding to the combination Cx, the monitoring criterion setting part 64 of the embodiment sets (A + 3σ) or (A - 3σ) to the monitoring criterion value. Alternatively, the monitoring criterion value may be obtained by another method. For example, a correlation analysis of the observation value and the measured value (the value measured by the inspection of the component) is performed with respect to plural components corresponding to the combination Cx, and the observation value corresponding to a predetermined inspection standard (for example, an occurrence probability of m% in the measured value distribution) may be set to a new monitoring criterion value.

### DESCRIPTION OF SYMBOLS

- 21: 20 Stage Feeder
- 22: Head
- 23: Nozzle
- 24: Vacuum pump
- 25: Upper camera
- 26: Lower camera
- 27: Contact sensor
- 28: Pressure sensor
- 29: Controller
- 60: Inspection data acquisition part
- 61: Observation data acquisition part
- 62: Causal factor estimator
- 63: Table storage
- 64: Monitoring criterion setting part
- B: Board
- P: Electronic component
- X1: Solder printing apparatus
- X2: Mounter
- X3: Reflow furnace
- X4: Production facility management apparatus
- Y1: Printing inspection apparatus
- Y2: Component inspection apparatus
- Y3: Appearance inspection apparatus
- Y4: X-ray inspection apparatus
- Y5: Inspection management apparatus
- Y6: Analyzer
- Y7: Workstation

## Claims

1. A quality management apparatus (Y6) adapted to perform quality management of a production line, wherein
a production facility having a plurality of production facility members for processing a product, and
an inspection apparatus adapted to inspect the product processed by the production facility are provided in the production line, wherein
the production facility comprises a function of observing a plurality of observation items each of which is respectively observed when an operation in the processing of the product using a respective one of the production facility members is executed, and of self-monitoring an observation value of each of the observation items in order to detect an operation abnormality in the processing of the product;
the quality management apparatus (Y6) comprising:
an inspection data acquisition part (60) configured to acquire inspection data obtained by the inspection apparatus, wherein the inspection data indicate whether the processed product has a product defect;
an observation data acquisition unit (61) configured to acquire observation data in which sthe observation value of each observation item observed with the production facility during the processing of each product is recorded;
a storage unit (63) storing a table comprising a correspondence between each of a plurality of abnormal events (Ex) that can occur in the production facility and a corresponding product defect of a plurality of product defects that can occur due to the abnormal events, and a table comprising a correspondence between each of the abnormal events (Ex) and the observation item in which a change of the observation value appears when the corresponding abnormal event occurs;
a causal factor estimator (62) configured to extract the abnormal event as a causal factor candidate when the product defect is detected, the abnormal event corresponding to the defect in the table, and to estimate whether the abnormal event is the causal factor by comparing the observation value of the observation item corresponding to the abnormal event of the causal factor candidate in the table, obtained during the processing of a defective product having the product defect to the observation value obtained during the processing of a nondefective product.

2. The quality management apparatus (Y6) according to claim 1, wherein the causal factor estimator determines that the operation abnormality of the production facility associated with the observation item is the causal factor when a significant change between the observation value during the processing of the defective to the observation value during the processing of the nondefective is recognized with respect to a certain observation item.

3. The quality management apparatus (Y6) according to claim 2, wherein the causal factor estimator considers that the significant change exists in the observation value when the observation value during the processing of the defective separates from an average of an observation value distribution during the processing of the nondefective by a predetermined distance or more.

4. The quality management apparatus (Y6) according to claim 3, wherein the predetermined distance is n times of a standard deviation of the observation value distribution during the processing of the nondefective.

5. The quality management apparatus (Y6) according to claim 4, wherein the causal factor estimator outputs information indicating a kind of the defect, information indicating the extracted causal factor candidate, and information indicating an estimation result of the causal factor.

6. The quality management apparatus (Y6) according to claim 5, wherein the causal factor estimator outputs the observation value during the processing of the product in which the defect is detected and information about the observation value during the processing of the nondefective.

7. The quality management apparatus (Y6) according to any one of claims 4 to 6, wherein the causal factor estimator outputs information indicating an abnormal place and the abnormal operation of the production facility with respect to the abnormal event estimated to be the causal factor.

8. The quality management apparatus (Y6) according to claim 7, wherein the causal factor estimator outputs the information indicating the kind of the defect and the information indicating the product in which the defect is detected together with the information indicating the abnormal place and the abnormal operation of the production facility.

9. The quality management apparatus (Y6) according to any one of claims 1 to 8, further comprising a monitoring criterion setting unit configured to decide a new monitoring criterion value used to monitor the observation value based on the observation value distribution of a plurality of products, wherein the monitoring function of the production facility is a function of determining that the abnormality occurs in the operation of the production facility when the observation value of a certain observation item is out of a normal range defined by a previously-set monitoring criterion value.

10. The quality management apparatus (Y6) according to claim 9, wherein the monitoring criterion setting unit outputs the new monitoring criterion value, automatically sets the new monitoring criterion value to the production facility, or sets the new monitoring criterion value to the production facility after permission to change the monitoring criterion value of the production facility is received from a user.

11. The quality management apparatus (Y6) according to any one of claims 1 to 10, wherein the production line is a surface mounting line for a printed circuit board, and
the production facility is a mounter that mounts an electronic component on the printed circuit board.

12. A method for controlling a quality management apparatus (Y6) that performs quality management of a production line,
a production facility having a plurality of production family members for processing a product, and an inspection apparatus that inspects a product processed with the production facility being provided in the production line, wherein
the production facility comprising a function of observing a plurality of observation items each of which is respectively observed when an operation in the processing of the product using a respective one of the production facility members is executed, and of self-monitoring an observation value of each of the observation items in order to detect an operation abnormality in the processing of the product,
the quality management apparatus controlling method comprising the steps of:
acquiring the inspection data which is obtained by the inspection apparatus, wherein the inspection data indicate whether the processed product has a product defect;
acquiring the observation data in which an observation value of each observation item observed with the production facility during the processing of each product is recorded;
storing a table comprising a correspondence between each of a plurality of abnormal events (Ex) that can occur in the production facility and a corresponding product defect of a plurality of product defects that can occur due to the abnormal events, and a table comprising a correspondence between each of the abnormal events (Ex) and the observation item in which a change of the observation value appears when the corresponding abnormal event occurs; and
extracting the abnormal event as a causal factor candidate when the product defect is detected, the abnormal event corresponding to the defect in the table, and estimating whether the abnormal event is the causal factor by comparing the observation value of the observation item corresponding to the abnormal event of the causal factor candidate in the table, obtained during the processing of a defective product having the product defect to the observation value obtained during the processing of a nondefective product.

13. A computer program, when execute on a computer, causing said computer to perform each step of the quality management apparatus (Y6) controlling method according to claim 12.

## Patentansprüche

1. Qualitätsverwaltungseinrichtung (Y6), die zum Ausführen von Qualitätsverwaltung auf eine Produktionslinie eingerichtet ist, wobei
eine Produktionsanlage mit mehreren Produktionsanlagegliedern zum Verarbeiten eines Produkts und
eine Inspektionseinrichtung, die zum Inspizieren des Produkts, das durch die Produktionsanlage verarbeitet wird, eingerichtet ist, in der Produktionslinie vorgesehen sind, wobei
die Produktionsanlage eine Funktion des Beobachtens von mehreren Beobachtungsobjekten, von denen jedes jeweils beobachtet wird, wenn ein Betrieb beim Verarbeiten des Produkts unter Benutzung eines jeweiligen der Produktionsanlagenglieder ausgeführt wird, und des Selbstüberwachens eines Beobachtungswerts von jedem der Beobachtungsobjekte zum Erkennen einer Betriebsanomalie beim Verarbeiten des Projekts umfasst;
wobei die Qualitätsverwaltungseinrichtung (Y6) umfasst:
ein Inspektionsdatenerfassungsteil (60), das zum Erfassen von Inspektionsdaten konfiguriert ist, die durch die Inspektionseinrichtung erhalten werden, wobei die Inspektionsdaten anzeigen, ob das verarbeitete Produkt einen Produktdefekt aufweist;
eine Beobachtungsdatenerfassungseinheit (61), die zum Erfassen von Beobachtungsdaten konfiguriert ist, in denen der Beobachtungswert von jedem
Beobachtungsobjekt, das mit der Produktionsanlage während des Verarbeitens von jedem Produkt beobachtet wurde, aufgezeichnet ist;
eine Speichereinheit (63), die eine Tabelle, welche eine Entsprechung zwischen jedem von mehreren anomalen Ereignissen (Ex), die in der Produktionsanlage auftreten können, und einem entsprechenden Produktdefekt von mehreren Produktdefekten, welche aufgrund der anomalen Ereignisse auftreten können, umfasst, und eine Tabelle speichert, die eine Entsprechung zwischen jedem der anomalen Ereignisse (Ex) und dem Beobachtungsobjekt, bei dem eine Änderung des Beobachtungswerts erscheint, wenn das entsprechende anomale Ereignis auftritt, umfasst;
einen Kausalfaktorschätzer (62), der zum Extrahieren des anomalen Ereignisses als einen Kausalfaktorkandidaten, wenn der Produktdefekt erkannt wird, wobei das anomale Ereignis dem Defekt in der Tabelle entspricht, und zum Schätzen konfiguriert ist, ob das anomale Ereignis der Kausalfaktor ist, durch Vergleichen des Beobachtungswerts des Beobachtungsobjekts, der dem anomalen Ereignis des Kausalfaktorkandidaten in der Tabelle entspricht und während des Verarbeitens eines defekten Produkts mit dem Produktdefekt erhalten wird, mit dem Beobachtungswert, der während des Verarbeitens eines nichtdefekten Produkts erhalten wird.

2. Qualitätsverwaltungseinrichtung (Y6) nach Anspruch 1, wobei der Kausalfaktorschätzer bestimmt, dass die Betriebsanomalie der Produktionsanlage, die mit dem Beobachtungsobjekt assoziiert ist, der Kausalfaktor ist, wenn eine erhebliche Änderung zwischen dem Beobachtungswert während des Verarbeitens des defekten Stücks und dem Beobachtungswert während des Verarbeitens des nichtdefekten Stücks bezüglich eines bestimmten Beobachtungsobjekts erkannt wird.

3. Qualitätsverwaltungseinrichtung (Y6) nach Anspruch 2, wobei der Kausalfaktorschätzer erachtet, dass die erhebliche Änderung im Beobachtungswert vorliegt, wenn der Beobachtungswert während des Verarbeitens des defekten Stücks von einem Mittel einer Beobachtungswertverteilung während des Verarbeitens des nichtdefekten Stücks um eine vorgegebene Distanz oder darüber abweicht.

4. Qualitätsverwaltungseinrichtung (Y6) nach Anspruch 3, wobei die vorgegebene Distanz das n-Fache einer Standardabweichung der Beobachtungswertverteilung während des Verarbeitens des nichtdefekten Stücks ist.

5. Qualitätsverwaltungseinrichtung (Y6) nach Anspruch 4, wobei der Kausalfaktorschätzer Information, die eine Art des Defekts anzeigt, Information, die den extrahierten Kausalfaktorkandidaten anzeigt, und Information, die ein Schätzungsergebnis des Kausalfaktors anzeigt, ausgibt.

6. Qualitätsverwaltungseinrichtung (Y6) nach Anspruch 5, wobei der Kausalfaktorschätzer den Beobachtungswert während des Verarbeitens des Produkts, bei dem der Defekt erkannt wird, und Information über den Beobachtungswert während des Verarbeitens des nichtdefekten Stücks ausgibt.

7. Qualitätsverwaltungseinrichtung (Y6) nach einem der Ansprüche 4 bis 6, wobei der Kausalfaktorschätzer Information ausgibt, die einen anomalen Platz und den anomalen Betrieb der Produktionsanlage bezüglich des anomalen Ereignisses, das als der Kausalfaktor eingeschätzt wird, anzeigt.

8. Qualitätsverwaltungseinrichtung (Y6) nach Anspruch 7, wobei der Kausalfaktorschätzer die Information, die die Art des Defekts anzeigt, und die Information, die das Produkt anzeigt, an dem der Defekt erkannt wurde, zusammen mit der Information ausgibt, die den anomalen Platz und den anomalen Betrieb der Produktionsanlage anzeigt.

9. Qualitätsverwaltungseinrichtung (Y6) nach einem der Ansprüche 1 bis 8, ferner umfassend eine Überwachungskriteriumeinstellungseinheit, die zum Festlegen eines neuen Überwachungskriteriumwerts, der zum Überwachen des Beobachtungswerts benutzt wird, basierend auf der Beobachtungswertverteilung von mehreren Produkten konfiguriert ist, wobei die Überwachungsfunktion der Produktionsanlage eine Funktion des Bestimmens ist, dass die Anomalie im Betrieb der Produktionsanlage auftritt, wenn der Beobachtungswert eines bestimmten Beobachtungsobjekts außerhalb eines normalen Bereichs liegt, der durch einen vorher eingestellten Überwachungskriteriumwert definiert ist.

10. Qualitätsverwaltungseinrichtung (Y6) nach Anspruch 9, wobei die Überwachungskriteriumeinstellungseinheit den neuen Überwachungskriteriumwert ausgibt, den neuen Überwachungskriteriumwert automatisch für die Produktionsanlage einstellt oder den neuen Überwachungskriteriumwert für die Produktionsanlage einstellt, nachdem Erlaubnis zum Ändern des Überwachungskriteriumwerts der Produktionsanlage von einem Benutzer empfangen wurde.

11. Qualitätsverwaltungseinrichtung (Y6) nach einem der Ansprüche 1 bis 10, wobei die Produktionslinie eine Oberflächenmontagelinie für eine Leiterplatte ist, und die Produktionsanlage eine Montiervorrichtung ist, die ein elektronisches Bauteil auf der Leiterplatte montiert.

12. Verfahren zum Steuern einer Qualitätsverwaltungseinrichtung (Y6), die Qualitätsverwaltung einer Produktionslinie ausführt,
wobei eine Produktionsanlage mit mehreren Produktionsfamiliengliedern zum Verarbeiten eines Produkts und eine Inspektionseinrichtung, die ein Produkt, das mit der Produktionsanlage verarbeitet wird, inspiziert, in der Produktionslinie vorgesehen sind, wobei
die Produktionsanlage eine Funktion des Beobachtens von mehreren Beobachtungsobjekten, die jedes jeweils beobachtet werden, wenn ein Betrieb beim Verarbeiten des Produkts unter Benutzung eines jeweiligen der Produktionsanlagenglieder ausgeführt wird, und des Selbstüberwachens eines Beobachtungswerts von jedem der Beobachtungsobjekte zum Erkennen einer Betriebsanomalie beim Verarbeiten des Projekts umfasst;
wobei das Qualitätsverwaltungseinrichtungs-Steuerverfahren die folgenden Schritte umfasst:
Erfassen der Inspektionsdaten, die durch die Inspektionseinrichtung erhalten werden, wobei die Inspektionsdaten anzeigen, ob das verarbeitete Produkt einen Produktdefekt aufweist;
Erfassen der Beobachtungsdaten, in denen der Beobachtungswert von jedem Beobachtungsobjekt, das mit der Produktionsanlage während des Verarbeitens von jedem Produkt beobachtet wurde, aufgezeichnet ist;
Speichern einer Tabelle, welche eine Entsprechung zwischen jedem von mehreren anomalen Ereignissen (Ex), die in der Produktionsanlage auftreten können, und einem entsprechenden Produktdefekt von mehreren Produktdefekten, welche aufgrund der anomalen Ereignisse auftreten können, umfasst, und einer Tabelle, die eine Entsprechung zwischen jedem der anomalen Ereignisse (Ex) und dem Beobachtungsobjekt, bei dem eine Änderung des Beobachtungswerts erscheint, wenn das entsprechende anomale Ereignis auftritt, umfasst; und
Extrahieren des anomalen Ereignisses als einen Kausalfaktorkandidaten, wenn der Produktdefekt erkannt wird, wobei das anomale Ereignis dem Defekt in der Tabelle entspricht, und Schätzen, ob das anomale Ereignis der Kausalfaktor ist, durch Vergleichen des Beobachtungswerts des Beobachtungsobjekts, der dem anomalen Ereignis des Kausalfaktorkandidaten in der Tabelle entspricht und während des Verarbeitens eines defekten Produkts mit dem Produktdefekt erhalten wird, mit dem Beobachtungswert, der während des Verarbeitens eines nichtdefekten Produkts erhalten wird.

13. Computerprogramm, das, wenn es auf einem Computer ausgeführt wird, bewirkt, dass der Computer jeden Schritt des Verfahrens zum Steuern der Qualitätsverwaltungseinrichtung (Y6) nach Anspruch 12 ausführt.

## Revendications

1. Appareil de gestion de la qualité (Y6) adapté pour réaliser une gestion de la qualité d'une ligne de production, dans lequel
une installation de production ayant une pluralité d'éléments d'installation de production pour traiter un produit, et
un appareil d'inspection adapté pour inspecter le produit traité par l'installation de production sont prévus dans la ligne de production, dans lequel
l'installation de production comprend une fonction d'observation d'une pluralité de points d'observation, dont chacun est respectivement observé lorsqu'un fonctionnement dans le traitement du produit utilisant un élément respectif des éléments d'installation de production est exécuté, et d'autosurveillance d'une valeur d'observation de chacun des points d'observation afin de détecter une anomalie de fonctionnement dans le traitement du produit ;
l'appareil de gestion de la qualité (Y6) comprenant :
une partie d'acquisition de données d'inspection (60) configurée pour acquérir des données d'inspection obtenues par l'appareil d'inspection, dans lequel les données d'inspection indiquent si le produit traité a un défaut de produit ;
une unité d'acquisition de données d'observation (61) configurée pour acquérir des données d'observation, dans laquelle la valeur d'observation de chaque point d'observation observé avec l'installation de production pendant le traitement de chaque produit est enregistrée ;
une unité de stockage (63) stockant une table comprenant une correspondance entre chacun d'une pluralité d'événements anormaux (Ex) qui peut se produire dans l'installation de production et un défaut de produit correspondant d'une pluralité de défauts de produit qui peut se produire en raison des événements anormaux, et une table comprenant une correspondance entre chacun des événements anormaux (Ex) et le point d'observation dans lequel une modification de la valeur d'observation apparaît lorsque l'événement anormal correspondant se produit ;
un estimateur de facteur causal (62) configuré pour extraire l'événement anormal comme un candidat de facteur causal lorsque le défaut de produit est détecté, l'événement anormal correspondant au défaut dans la table, et pour estimer si l'événement anormal est le facteur causal en comparant la valeur d'observation du point d'observation correspondant à l'événement anormal du candidat de facteur causal dans la table, obtenue pendant le traitement d'un produit défectueux ayant le défaut de produit, à la valeur d'observation obtenue pendant le traitement d'un produit non défectueux.

2. Appareil de gestion de la qualité (Y6) selon la revendication 1, dans lequel l'estimateur de facteur causal détermine que l'anomalie de fonctionnement de l'installation de production associée au point d'observation est le facteur causal lorsqu'une modification significative entre la valeur d'observation pendant le traitement du défectueux et la valeur d'observation pendant le traitement du non défectueux est reconnue par rapport à un certain point d'observation.

3. Appareil de gestion de la qualité (Y6) selon la revendication 2, dans lequel l'estimateur de facteur causal considère que la modification significative existe dans la valeur d'observation lorsque la valeur d'observation pendant le traitement du défectueux se sépare d'une moyenne d'une répartition de valeur d'observation pendant le traitement du non défectueux par une distance prédéterminée ou plus.

4. Appareil de gestion de la qualité (Y6) selon la revendication 3, dans lequel la distance prédéterminée est égale à n fois un écart-type de la répartition de valeur d'observation pendant le traitement du non défectueux.

5. Appareil de gestion de la qualité (Y6) selon la revendication 4, dans lequel l'estimateur de facteur causal délivre des informations indiquant un type du défaut, des informations indiquant le candidat de facteur causal extrait, et des informations indiquant un résultat d'estimation du facteur causal.

6. Appareil de gestion de la qualité (Y6) selon la revendication 5, dans lequel l'estimateur de facteur causal délivre la valeur d'observation pendant le traitement du produit dans lequel le défaut est détecté et des informations sur la valeur d'observation pendant le traitement du non défectueux.

7. Appareil de gestion de la qualité (Y6) selon l'une quelconque des revendications 4 à 6, dans lequel l'estimateur de facteur causal délivre des informations indiquant un emplacement anormal et le fonctionnement anormal de l'installation de production par rapport à l'événement anormal estimé comme étant le facteur causal.

8. Appareil de gestion de la qualité (Y6) selon la revendication 7, dans lequel l'estimateur de facteur causal délivre les informations indiquant le type du défaut et les informations indiquant le produit dans lequel le défaut est détecté, ainsi que les informations indiquant l'emplacement anormal et le fonctionnement anormal de l'installation de production.

9. Appareil de gestion de la qualité (Y6) selon l'une quelconque des revendications 1 à 8, comprenant en outre une unité de réglage de critères de surveillance configurée pour décider d'une nouvelle valeur de critère de surveillance utilisée pour surveiller la valeur d'observation sur la base de la répartition de valeurs d'observation d'une pluralité de produits, dans lequel la fonction de surveillance de l'installation de production est une fonction consistant à déterminer que l'anomalie se produit dans le fonctionnement de l'installation de production lorsque la valeur d'observation d'un certain point d'observation se trouve en dehors d'une plage normale définie par une valeur de critère de surveillance préalablement réglée.

10. Appareil de gestion de la qualité (Y6) selon la revendication 9, dans lequel l'unité de réglage de critères de surveillance délivre la nouvelle valeur de critère de surveillance, règle automatiquement la nouvelle valeur de critère de surveillance sur l'installation de production, ou règle la nouvelle valeur de critère de surveillance sur l'installation de production après qu'une permission de modification de la valeur de critère de surveillance de l'installation de production a été reçue d'un utilisateur.

11. Appareil de gestion de la qualité (Y6) selon l'une quelconque des revendications 1 à 10, dans lequel la ligne de production est une ligne de montage de surface pour une carte de circuit imprimé, et
l'installation de production est un dispositif de montage qui monte un composant électronique sur la carte de circuit imprimé.

12. Méthode pour commander un appareil de gestion de la qualité (Y6) qui réalise une gestion de la qualité d'une ligne de production,
une installation de production ayant une pluralité d'éléments de production apparentés pour traiter un produit, et un appareil d'inspection qui inspecte un produit traité, l'installation de production étant prévue dans la ligne de production, dans laquelle
l'installation de production comprend une fonction d'observation d'une pluralité de points d'observation, dont chacun est respectivement observé lorsqu'un fonctionnement dans le traitement du produit utilisant un élément respectif des éléments d'installation de production est exécuté, et d'autosurveillance d'une valeur d'observation de chacun des points d'observation afin de détecter une anomalie de fonctionnement dans le traitement du produit,
la méthode de commande d'appareil de gestion de la qualité comprenant les étapes consistant à :
acquérir les données d'inspection qui sont obtenues par l'appareil d'inspection, dans laquelle les données d'inspection indiquent si le produit traité a un défaut de produit ;
acquérir les données d'observation dans lesquelles une valeur d'observation de chaque point d'observation observé avec l'installation de production pendant le traitement de chaque produit est enregistrée ;
stocker une table comprenant une correspondance entre chacun d'une pluralité d'événements anormaux (Ex) qui peut se produire dans l'installation de production et un défaut de produit correspondant d'une pluralité de défauts de produit qui peut se produire en raison des événements anormaux, et une table comprenant une correspondance entre chacun des événements anormaux (Ex) et le point d'observation dans laquelle une modification de la valeur d'observation apparaît lorsque l'événement anormal correspondant se produit ; et
extraire l'événement anormal comme un candidat de facteur causal lorsque le défaut de produit est détecté, l'événement anormal correspondant au défaut dans la table, et estimer si l'événement anormal est le facteur causal, en comparant la valeur d'observation du point d'observation correspondant à l'événement anormal du candidat de facteur causal dans la table, obtenue pendant le traitement d'un produit défectueux ayant le défaut de produit, à la valeur d'observation obtenue pendant le traitement d'un produit non défectueux.

13. Programme informatique, qui, lorsqu'il est exécuté sur un ordinateur, amène ledit ordinateur à réaliser chaque étape de la méthode de commande d'appareil de gestion de la qualité (Y6) selon la revendication 12.
